(19) Europäisches Patentamt / European Patent Office / Office européen des brevets

(11) **EP 4 435 142 A1**

(12) **EUROPEAN PATENT APPLICATION**

(43) Date of publication:
**25.09.2024 Bulletin 2024/39**

(21) Application number: **24155984.8**

(22) Date of filing: **06.02.2024**

(51) International Patent Classification (IPC):
**C23C 16/02** (2006.01)    **C23C 16/04** (2006.01)
**C23C 16/34** (2006.01)    **C23C 16/40** (2006.01)
**C23C 16/455** (2006.01)    **C23C 16/46** (2006.01)
**C23C 16/52** (2006.01)    **C23C 16/56** (2006.01)
**H01L 21/02** (2006.01)

(52) Cooperative Patent Classification (CPC):
**H01L 21/02164; C23C 16/0272; C23C 16/045;
C23C 16/345; C23C 16/401; C23C 16/45534;
C23C 16/45553; C23C 16/45557; C23C 16/46;
C23C 16/52; C23C 16/56; H01L 21/0217;
H01L 21/02211; H01L 21/02219; H01L 21/0228;**

(Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.02.2023 JP 2023026842**

(71) Applicant: **Kokusai Electric Corp.
Tokyo 1010045 (JP)**

(72) Inventor: **NAKATANI, Kimihiko
Toyama-shi, Toyama, 9392393 (JP)**

(74) Representative: **Bardehle Pagenberg
Partnerschaft mbB
Patentanwälte Rechtsanwälte
Prinzregentenplatz 7
81675 München (DE)**

(54) **METHOD OF PROCESSING SUBSTRATE, METHOD OF MANUFACTURING SEMICONDUCTOR DEVICE, SUBSTRATE PROCESSING APPARATUS, AND PROGRAM**

(57) There is provided a technique that includes: forming a film on a surface of a substrate by performing a cycle a predetermined number of times, the cycle including: (a) supplying an inhibitor to the substrate, which includes the surface including first adsorption sites capable of adsorbing an intermediate produced from a precursor but incapable of adsorbing the precursor and second adsorption sites capable of adsorbing the precursor and the intermediate, and causing the inhibitor to be adsorbed to the first adsorption sites and the second adsorption sites; and (b) supplying the precursor to the substrate after the inhibitor is adsorbed to the first adsorption sites and the second adsorption sites, producing the intermediate from the precursor, desorbing the inhibitor adsorbed to the second adsorption sites, and causing the precursor and the intermediate to be adsorbed to the second adsorption sites to form a first layer.

FIG. 4

**(Cont. next page)**

(52) Cooperative Patent Classification (CPC): (Cont.)
   **H01L 21/0234**

**Description**

CROSS-REFERENCE TO RELATED APPLICATION

This application is based upon and claims the benefit of priority from Japanese Patent A pplication No. 2023-026842, filed on February 24, 2023, the entire contents of which are incorp orated herein by reference.

TECHNICAL FIELD

The present disclosure relates to a method of processing a substrate, a method of manufa cturing a semiconductor device, a substrate processing apparatus, and a program.

BACKGROUND

In a related art, there are cases in which a process for forming a film on a substrate is per formed as a process of manufacturing a semiconductor device.
With miniaturizations of semiconductor devices, there is a strong demand to improve an d enhance characteristics of the film formed on the substrate.

SUMMARY

Some embodiments of the present disclosure provide a technique capable of improving c haracteristics of a film formed on a substrate.
According to embodiments of the present disclosure, there is provided a technique that i ncludes forming a film on a surface of a substrate by performing a cycle a predetermined numbe r of times, the cycle including: (a) supplying an inhibitor to the substrate, which includes the sur face including first adsorption sites capable of adsorbing an intermediate produced from a precu rsor but incapable of adsorbing the precursor and second adsorption sites capable of adsorbing t he precursor and the intermediate, and causing the inhibitor to be adsorbed to the first adsorpti on sites and the second adsorption sites; and (b) supplying the precursor to the substrate after t he inhibitor is adsorbed to the first adsorption sites and the second adsorption sites, producing t he intermediate from the precursor, desorbing the inhibitor adsorbed to the second adsorption s ites, and causing the precursor and the intermediate to be adsorbed to the second adsorption sit es to form a first layer.

BRIEF DESCRIPTION OF DRAWINGS

The accompanying drawings, which are incorporated in and constitute a part of the speci fication, illustrate embodiments of the present disclosure.

FIG. 1 is a schematic configuration diagram of a vertical process furnace of a substrate pr ocessing apparatus suitably used in one embodiment of the present disclosure, and is illustratin g a portion of the process furnace 202 in a vertical cross-sectional view.

FIG. 2 is a schematic configuration diagram of the vertical process furnace of the substra te processing apparatus suitably used in one embodiment of the present disclosure and is illustr ating a portion of the process furnace 202 in a cross-sectional view taken along line A-A in FIG. 1.

FIG. 3 is a schematic configuration diagram of a controller 121 of the substrate processin g apparatus suitably used in one embodiment of the present disclosure, and is illustrating a cont rol system of the controller 121in a block diagram.

FIG. 4 is a diagram showing a processing sequence in one embodiment of the present dis closure.

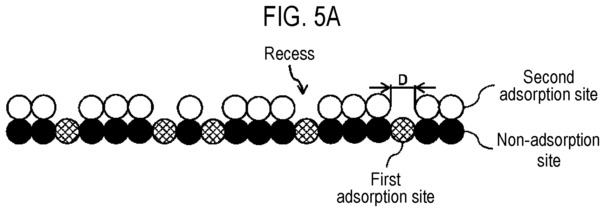

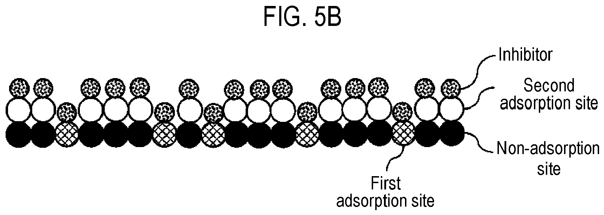

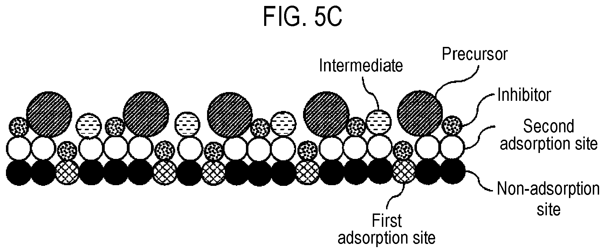

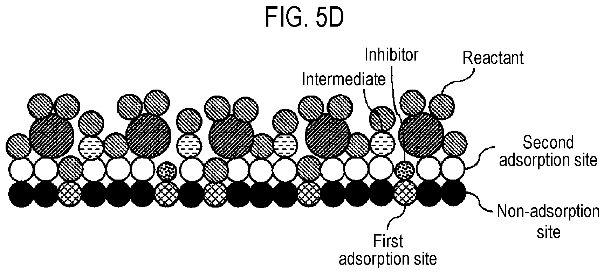

FIG. 5A is a schematic cross-sectional view showing a surface state of a wafer including, on a surface, first adsorption sites capable of adsorbing an intermediate produced from a precur sor but incapable of adsorbing a precursor and second adsorption sites capable of adsorbing the precursor and the intermediate. FIG. 5B is a schematic cross-sectional view showing a surface st ate of the wafer after an inhibitor is supplied to the wafer from the surface state shown in FIG. 5 A. FIG. 5C is a schematic cross-sectional view showing a surface state of the wafer after the prec ursor is supplied to the wafer from the surface state shown in FIG. 5B. FIG. 5D is a schematic cr oss-sectional view showing a surface state of the wafer after a reactant is supplied to the wafer fr om the surface state shown in FIG. 5C.

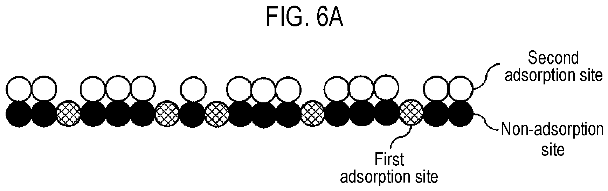

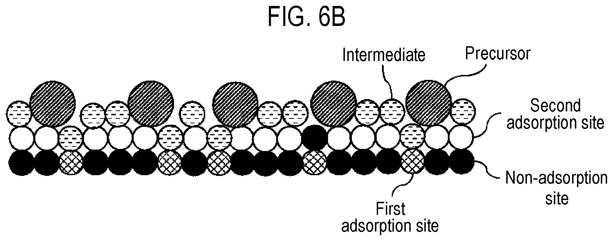

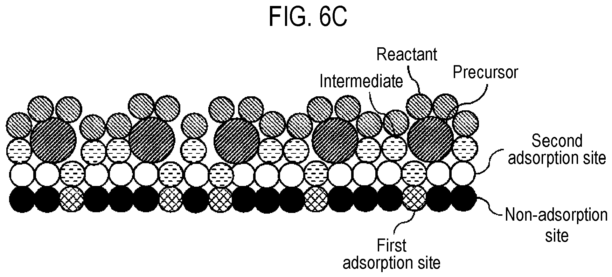

FIG. 6A is a schematic cross-sectional view showing a surface state of a wafer including, on a surface, first adsorption sites capable of adsorbing an intermediate produced from a precur sor but incapable of adsorbing a precursor and second adsorption sites capable of adsorbing the precursor and the intermediate. FIG. 6B is a schematic cross-sectional view showing a surface s tate of the wafer after the precursor is supplied to the wafer from the surface state shown in FIG. 6A. FIG. 6C is a schematic cross-sectional view showing a surface state of the wafer after a react ant is supplied to the wafer from the surface state shown in FIG. 6B.

FIG. 7 is a schematic cross-sectional view showing a surface of a wafer on which a hole or a trench is provided.

DETAILED DESCRIPTION

Reference will now be made in detail to various embodiments, examples of which are illu strated in the accompanying drawings. In the following detailed description, numerous specific details are set forth to provide a thorough understanding of the present disclosure. However, it will be apparent to one of ordinary skill in the art that the present disclosure may be practiced w ithout these specific details. In other instances, well-known methods, procedures, systems, and components are not been described in detail so as not to unnecessarily obscure aspects of the va rious embodiments.

<One Embodiment of the Present Disclosure>

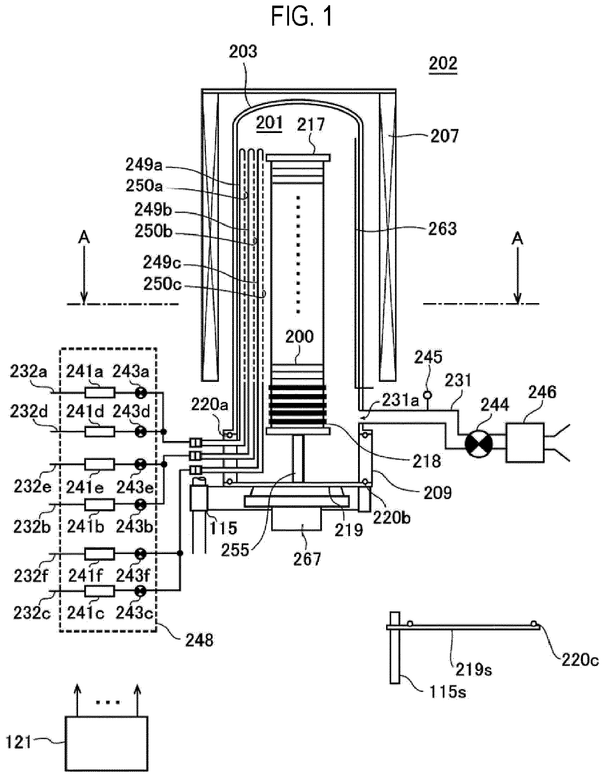

Hereinafter, one embodiment of the present disclosure will be described mainly with refe rence to FIGS. 1 to 4 and 5A to 5D. The drawings used in the following description are schemati c, and the dimensional relationship of each element, the ratio of each element, and the like show n in the drawings may not correspond to the actual ones. Moreover, the dimensional relationshi p of each element, the ratio of each element, and the like may not match among a plurality of dra wings.

(1) Configuration of Substrate Processing Apparatus

As shown in FIG. 1, a process furnace 202 of a substrate processing apparatus includes a heater 207 as a temperature regulator (heating part). The heater 207 is formed in a cylindrical s hape and is vertically installed by being supported by a holding plate. The heater 207 functions as an activator (exciter) that activates (excites) a gas with heat.

Inside the heater 207, a reaction tube 203 is disposed concentrically with the heater 207. The reaction tube 203 is made of a heat-resistant material such as, for example, quartz ($SiO_2$) or silicon carbide (SiC), and is formed in a cylindrical shape with an upper end thereof closed and a lower end thereof opened. Below the reaction tube 203, a manifold 209 is disposed concentrical ly with the reaction tube 203. The manifold 209 is made of a metallic material such as stainless steel (SUS) or the like, and is formed in a cylindrical shape with upper and lower ends thereof op ened. The upper end of the manifold 209 is engaged with the lower end of the reaction tube 203, and is configured to support the reaction tube 203. An O-ring 220a as a seal member is provid ed between the manifold 209 and the reaction tube 203. The reaction tube 203 is installed verti cally just like the heater 207. A process container (reaction container) mainly includes the reacti on tube 203 and the manifold 209. A process chamber 201 is formed in a hollow area of the pro cess container. The process chamber 201 is configured to accommodate wafers 200 as substrate s. The wafers 200 are processed in the process chamber 201.

Nozzles 249a to 249c as first to third suppliers are provided at the process chamber 201 and penetrate a side wall of the manifold 209. The nozzles 249a to 249c are also referred to as fi rst to third nozzles, respectively. The nozzles 249a to 249c are made of, for example, a heat-resi stant material such as quartz or SiC. Gas supply pipes 232a to 232c are connected to the nozzles 249a to 249c, respectively. Each of the nozzles 249a to 249c is a different nozzle, and each of th e nozzles 249a and 249c is provided adjacent to the nozzle 249b.

On the gas supply pipes 232a to 232c, mass flow controllers (MFCs) 241a to 241c, which are flow rate controllers (flow rate control parts), and valves 243a to 243c, which are on-off valv es, are respectively provided sequentially from an upstream side of a gas flow. A gas supply pipe 232d is connected to the gas supply pipe 232a on a downstream side of the valve 243a. A gas su pply pipe 232e is connected to the gas supply pipe 232b on a downstream side of the valve 243b. A gas supply pipe 232f is connected to the gas supply pipe 232c on a downstream side of the valv e 243c. On the gas supply pipes 232d to 232f, MFCs 241d to 241f and valves 243d to 243f are re spectively provided sequentially from an upstream side of a gas flow. The gas supply pipes 232a to 232f are made of, for example, a metallic material such as stainless steel or the like.

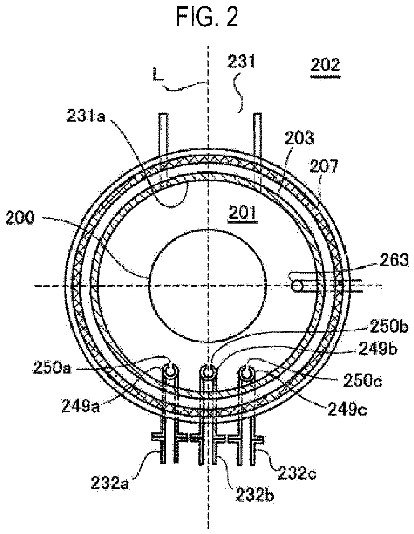

As shown in FIG. 2, the nozzles 249a to 249c are disposed in a space of an annular shape in a plane view between an inner wall of the reaction tube 203 and the wafers 200, and are instal led to extend upward in an arrangement direction of the wafers 200 from a lower side to an upper side of the inner wall of the reaction tube 203. In other words, the nozzles 249a to 249c are respectively installed in a region horizontally surrounding a wafer arrangement region, in which the wafers 200 are arranged, at a lateral side of the wafer arrangement region, to extend along the wafer arrangement region. In a plane view, the nozzle 249b is disposed to face a below-described exhaust port 231a on a straight line across a center of the wafers 200 in the process chamber 201. The nozzles 249a and 249c are disposed to sandwich a straight line L passing through the nozzle 249b and a center of the exhaust port 231a from both sides along the inner wall of the reaction tube 203 (outer peripheral sides of the wafers 200). The straight line L is also a straight line passing through the nozzle 249b and the center of the wafers 200. That is, it may be said that the nozzle 249c is installed on a side opposite to the nozzle 249a with the straight line L interposed therebetween. The nozzles 249a and 249c are arranged line-symmetrically with the straight line L as an axis of symmetry. Gas supply holes 250a to 250c for supplying gases are formed on side surfaces of the nozzles 249a to 249c, respectively. Each of the gas supply holes 250a to 250c is opened to face the exhaust port 231a in a plane view and is configured to be capable of supplying the gases toward the wafers 200. The gas supply holes 250a to 250c are formed from a lower side to an upper side of the reaction tube 203.

An inhibitor is supplied from the gas supply pipe 232a into the process chamber 201 through the MFC 241a, the valve 243a, and the nozzle 249a.

A precursor is supplied from the gas supply pipe 232b into the process chamber 201 through the MFC 241b, the valve 243b, and the nozzle 249b.

A reactant is supplied from the gas supply pipe 232c into the process chamber 201 through the MFC 241c, the valve 243c, and the nozzle 249c.

An inert gas is supplied from the gas supply pipes 232d to 232f into the process chamber 201 through the MFCs 241d to 241f, the valves 243d to 243f, the gas supply pipes 232a to 232c, and the nozzles 249a to 249c, respectively. The inert gases act as a purge gas, a carrier gas, a dilution gas, and the like.

An inhibitor supply system mainly includes the gas supply pipe 232a, the MFC 241a, and the valve 243a. A precursor supply system mainly includes the gas supply pipe 232b, the MFC 241b, and the valve 243b. A reactant supply system mainly includes the gas supply pipe 232c, the MFC 241c, and the valve 243c. An inert gas supply system mainly includes the gas supply pipes 232d to 232f, the MFCs 241d to 241f, and the valves 243d to 243f.

Any or the entirety of the various supply systems described above may be configured as an integrated supply system 248 in which the valves 243a to 243f, the MFCs 241a to 241f and the like are integrated. The integrated supply system 248 is connected to each of the gas supply pipes 232a to 232f, and is configured such that operations of supplying various substances (various gases) into the gas supply pipes 232a to 232f, i.e., opening/closing operations of the valves 243a to 243f, flow rate regulation operations by the MFCs 241a to 241f, and the like are controlled by a controller 121, which will be described later. The integrated supply system 248 is configured as an integral or divided integrated unit, and is configured to be capable of being attached and detached to and from the gas supply pipes 232a to 232f, and the like on an integrated unit basis, such that maintenance, replacement, expansion, and the like of the integrated supply system 248 may be performed on the integrated unit basis.

An exhaust port 231a for exhausting atmosphere in the process chamber 201 is provided at a lower side of a side wall of the reaction tube 203. As shown in FIG. 2, the exhaust port 231a is provided at a position facing the nozzles 249a to 249c (gas supply holes 250a to 250c) with the wafers 200 interposed therebetween in a plane view. The exhaust port 231a may be provided to extend from the lower side to an upper side of the side wall of the reaction tube 203, i.e., along the wafer arrangement region. An exhaust pipe 231 is connected to the exhaust port 231a. A vacuum pump 246 as a vacuum exhauster is connected to the exhaust pipe 231 via a pressure sensor 245 as a pressure detector (pressure detection part) for detecting pressure inside the process chamber 201 and an APC (Auto Pressure Controller) valve 244 as a pressure regulator (pressure regulation part). The APC valve 244 is configured to be opened or closed in a state in which the vacuum pump 246 is in operation to perform vacuum exhaust or stop vacuum exhaust of an interior of the process chamber 201. Furthermore, the APC valve 244 is configured to adjust a valve-opening state based on pressure information detected by the pressure sensor 245 in a state in which the vacuum pump 246 is in operation to regulate the pressure inside the process chamber 201. An exhaust system mainly includes the exhaust pipe 231, the APC valve 244 and the pressure sensor 245. The vacuum pump 246 may be included in the exhaust system.

A seal cap 219 as a furnace opening lid capable of airtightly closing a lower end opening of the manifold 209 is installed below the manifold 209. The seal cap 219 is made of a metallic material such as, for example, stainless steel or the like, and is formed in a disc shape. On an upper surface of the seal cap 219, there is installed an O-ring 220b as a seal member which abuts against a lower end of the manifold 209. Below the seal cap 219, there is installed a rotator 267 for rotating a boat 217 to be described later. A rotating shaft 255 of the rotator 267 is connected to the boat 217 through the seal cap 219. The rotator 267 is configured to rotate the wafers 200 by rotating the boat 217. The seal cap 219 is configured to be raised and lowered in a vertical direction by a boat elevator 115 as an elevator installed outside the reaction tube 203. The boat elevator 115 is configured as a transporter (transport mechanism) that loads and unloads (transports) the wafers 200 into and out of the process chamber 201 by raising and lowering the seal cap 219.

Below the manifold 209, a shutter 219s is installed as a furnace opening lid capable of air tightly closing the lower end opening of the manifold 209 in a state in which the seal cap 219 is l owered and the boat 217 is unloaded from the process chamber 201. The shutter 219s is made of a metallic material such as stainless steel or the like and is formed in a disk shape. An O-ring 22 oc as a seal member that abuts against the lower end of the manifold 209 is installed on an uppe r surface of the shutter 219s. Opening/closing operations (an elevating operation, a rotating ope ration, and the like) of the shutter 219s are controlled by a shutter opening/closing mechanism 1 15s.

A boat 217 as a substrate support is configured to support a plurality of wafers 200, for e xample, 25 to 200 wafers 200 in a horizontal posture and in multiple stages along a vertical dire ction with the centers thereof aligned with one another, i.e., to arrange the wafers 200 at interva ls. The boat 217 is made of a heat-resistant material such as, for example, quartz or SiC. Heat in sulating plates 218 made of a heat-resistant material such as, for example, quartz or SiC, are sup ported in multiple stages at a bottom of the boat 217.

Inside the reaction tube 203, there is installed a temperature sensor 263 as a temperatur e detector. By regulating a state of supply of electric power to the heater 207 based on temperat ure information detected by the temperature sensor 263, a temperature inside the process cham ber 201 becomes a desired temperature distribution. The temperature sensor 263 is installed al ong the inner wall of the reaction tube 203.

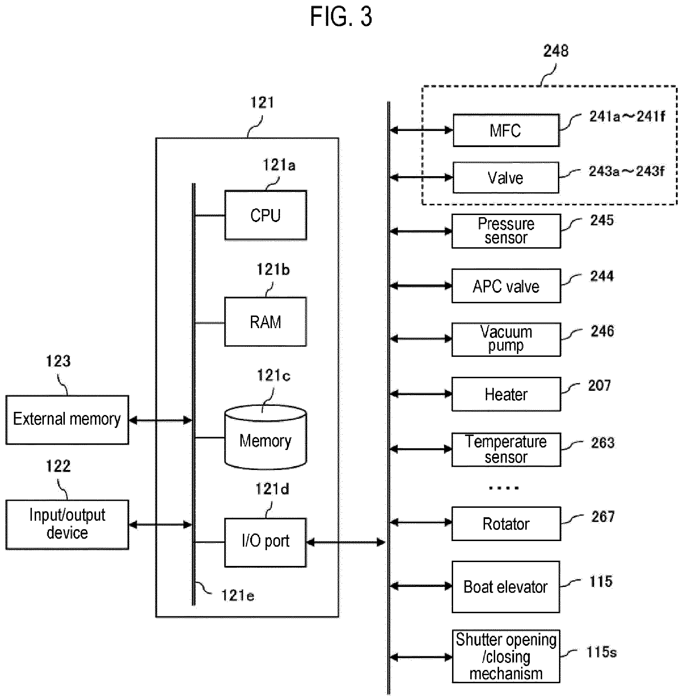

As shown in FIG. 3, the controller 121 as a control part (control means or unit) is configu red as a computer including a CPU (Central Processing Unit) 121a, a RAM (Random Access Me mory) 121b, a memory 121c and an I/O port 121d. The RAM 121b, the memory 121c and the I/O port 121d are configured to be capable of exchanging data with the CPU 121a via an internal bus 121e. An input/output device 122 including, for example, a touch panel or the like is connected t o the controller 121. In addition, an external memory 123 may be connected to the controller 121

The memory 121c includes, for example, a flash memory, an HDD (Hard Disk Drive), an SSD (Solid State Drive), or the like. In the memory 121c, there are readably recorded and stored a control program that controls the operation of the substrate processing apparatus, a process re cipe in which procedures and conditions of substrate processing described below are written, an d the like. The process recipe is a combination that causes, by the controller 121, the substrate p rocessing apparatus to execute the respective procedures in a below-described substrate process ing process to obtain a predetermined result. The process recipe functions as a program. Herei nafter, the process recipe, the control program and the like are collectively and simply referred t o as a program. Furthermore, the process recipe is simply referred to as a recipe. When the ter m "program" is used herein, it may mean a case of including the recipe, a case of including the c ontrol program, or a case of including both the recipe and the control program. The RAM 121b i s configured as a memory area (work area) in which programs, data and the like read by the CP U 121a are temporarily held.

The I/O port 121d is connected to the MFCs 241a to 241f, the valves 243a to 243f, the pre ssure sensor 245, the APC valve 244, the vacuum pump 246, the temperature sensor 263, the he ater 207, the rotator 267, the boat elevator 115, the shutter opening/closing mechanism 115s, an d the like.

The CPU 121a is configured to be capable of reading and executing the control program f rom the memory 121c and reading the recipe from the memory 121c in response to an input of a n operation command from the input/output device 122 or the like. The CPU 121a is configured to be capable of, according to the contents of the recipe thus read, controlling the flow rate regul ating operations for various substances (various gases) by the MFCs 241a to 241f, the opening/cl osing operations of the valves 243a to 243f, the opening/closing operation of the APC valve 244, the pressure regulating operation by the APC valve 244 based on the pressure sensor 245, the st art and stop of the vacuum pump 246, the temperature regulating operation of the heater 207 ba sed on the temperature sensor 263, the rotation and the rotation speed adjusting operation of th e boat 217 by the rotator 267, the raising and lowering operation of the boat 217 by the boat elev ator 115, the opening/closing operation of the shutter 219s by the shutter opening/closing mech anism 115s, and the like.

The controller 121 may be configured by installing, in the computer, the above-described program recorded and stored in an external memory 123. The external memory 123 includes, fo r example, a magnetic disk such as a HDD or the like, an optical disk such as a CD or the like, a magneto-optical disk such as an MO or the like, a semiconductor memory such as a USB memor y, a SSD, or the like, and so forth. The memory 121c and the external memory 123 are configure d as a computer readable recording medium. Hereinafter, the memory 121c and the external me mory 123 are collectively and simply referred to as a recording medium. As used herein, the ter m "recording medium" may include the memory 121c, the external memory 123, or both. The pr ogram may be provided to the computer by using a communication means such as the Internet o r a dedicated line without using the external memory 123.

(2) Substrate Processing Process

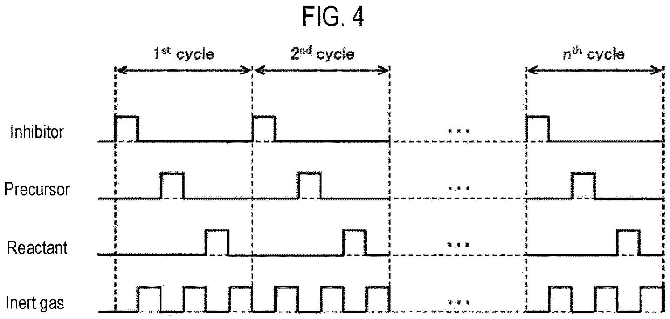

An example of a method of processing a substrate, i.e., a processing sequence for formin g a film on a surface of a wafer 200 as a substrate, as a process of manufacturing a semiconducto r device, by using the above-described substrate processing apparatus will be described mainly with reference to FIGS. 4 and 5A to 5D. In the following description, operations of respective co mponents constituting the substrate processing apparatus are controlled by the controller 121.

A processing sequence according to embodiments of the present disclosure includes:
performing a cycle a predetermined number of times (n times, where n is an integer equ al to or greater than 1), the cycle including:

(a) step (inhibitor supply step) of supplying an inhibitor to a wafer 200, which i ncludes the surface including first adsorption sites capable of adsorbing an intermediate produced from a precursor but incapable of adsorbing the precursor and second adsorpt ion sites capable of adsorbing the precursor and the intermediate, and causing the inhib itor to be adsorbed to the first adsorption sites and the second adsorption sites; and

(b) step (precursor supply step) of supplying the precursor to the wafer 200 afte r the inhibitor is adsorbed to the first adsorption sites and the second adsorption sites, p roducing the intermediate from the precursor, desorbing the inhibitor adsorbed to the s econd adsorption sites, and causing the precursor and the intermediate to be adsorbed t o the second adsorption sites to form a first layer.

Hereinafter, a case will be described in which the above-mentioned cycle further include s: (c) step (reactant supply step) of supplying a reactant to the wafer 200 to modify the first layer into a second layer. The processing sequence shown in FIG. 4 will be described as a typical exa mple in which the inhibitor supply step, the precursor supply step, and the reactant supply step are performed in the named order in the above-mentioned cycle.

In this specification, the processing sequence described above may also be denoted as fol lows for the sake of convenience. The same notation is also used in the following description of modifications and other embodiments.

$$(\text{inhibitor} \rightarrow \text{precursor} \rightarrow \text{reactant}) \times n$$

The term "wafer" used herein may refer to "a wafer itself" or "a stacked body of a wafer a nd a predetermined layer or film formed on the surface of the wafer." The phrase "a surface of a wafer" used herein may refer to "a surface of a wafer itself" or "a surface of a predetermined laye r or the like formed on a wafer." The expression "a predetermined layer is formed on a wafer" us ed herein may mean that "a predetermined layer is directly formed on a surface of a wafer itself" or that "a predetermined layer is formed on a layer or the like formed on a wafer". The term "su bstrate" used herein may be synonymous with the term "wafer."

As used herein, terms such as "inhibitor," "precursor," "reactant," and "substance" includ e at least one selected from the group of gaseous substances and liquid substances. The liquid s ubstances include mist substances. That is, each of the inhibitor, the precursor and the reactant may include gaseous substances, liquid substances such as mist substances or the like, or both of them.

As used herein, the term "layer" includes at least one selected from the group of a contin uous layer and a discontinuous layer. For example, each of the first layer and the second layer m ay include a continuous layer, a discontinuous layer, or both of them.

(Wafer Charging and Boat Loading)

After a plurality of wafers 200 is charged to the boat 217 (wafer charging), the shutter 21 9s is moved by the shutter opening/closing mechanism 115s to open the lower end opening of th e manifold 209 (shutter opening). Thereafter, as shown in FIG. 1, the boat 217 supporting the pl urality of wafers 200 is lifted by the boat elevator 115 and loaded into the process chamber 201 ( boat loading). In this state, the seal cap 219 seals the lower end of the manifold 209 via the O-ri ng 220b. Thus, the wafer 200 is prepared (provided) in the process chamber 201.

As shown in FIG. 5A, the surface of the wafer 200 includes recesses of a molecular or ato mic level size. First adsorption sites are located at a bottom side of the recesses, and second ads orption sites are located at an upper side of the recesses. These adsorption sites include, for exa mple, NH terminations.

Atoms constituting the second adsorption sites are separated in at least a portion of the s econd adsorption sites, and a distance between the atoms in separation (hereinafter, this distanc e is also referred to as a separation distance D) is shorter than a molecular width (molecular size or molecular diameter) of the precursor supplied to the wafer 200 in the precursor supply step d escribed later. That is, the separation distance D is set such that a molecule of the precursor is n ot able to pass through. The atoms constituting the second adsorption sites constitute steric hin drance that inhibits the adsorption (reaching) of the precursor to the first adsorption sites in the precursor supply step described below.

Further, the above-mentioned separation distance D is longer than a width (molecular si ze or molecular diameter) of a molecule of the intermediate produced from the precursor in the precursor supply step described later, and is longer than a width (molecular size or molecular di ameter) of a molecule of the inhibitor supplied to the wafer 200 in the inhibitor supply step desc ribed later. That is, the separation distance D is set such that each molecule of the intermediate and the inhibitor is not able to pass through. The atoms constituting the second adsorption sites do not constitute steric hindrance that inhibits the adsorption (reaching) of the inhibitor to the f irst adsorption sites in the inhibitor supply step described later, and do not constitute steric hin drance that inhibits adsorption (reaching) of the intermediate produced from the precursor to th e first adsorption sites.

For these reasons, both the first adsorption sites and the second adsorption sites functio n as adsorption sites capable of adsorbing the inhibitor in the inhibitor supply step described bel ow. In addition, the first adsorption sites function as adsorption sites that are capable of adsorbi ng the intermediate produced from the precursor but are incapable of adsorbing the precursor i n the precursor supply step described below, and the second adsorption sites function as adsorp tion sites that are capable of adsorbing the precursor and the intermediate in the precursor supp ly step described below.

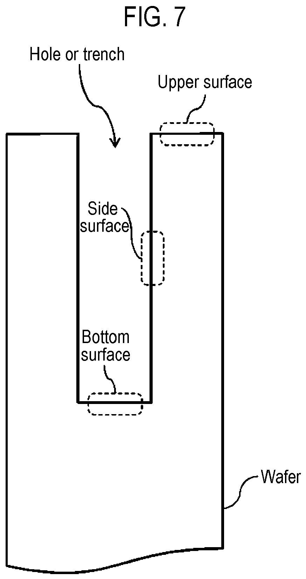

As shown in FIG. 7, the surface of the wafer 200 may be provided with a three-dimensio nal structure such as a hole or a trench. In this case as well, an entire surface of the three-dimen sional structure is in the above-mentioned surface state. That is, each of upper, side, and botto m surfaces of the hole or the trench in FIG. 7 includes recesses of a molecular or atomic level siz e, as shown in FIG. 5A. The above-mentioned first adsorption sites are located at the bottom sid e of each of the recesses, and the above-mentioned second adsorption sites are located at the up per side of each of the recesses.

(Pressure Regulation and Temperature Adjustment)

After the boat loading is completed, an inside of the process chamber 201, i.e., a space w here the wafers 200 are placed, is vacuum-exhausted (decompression-exhausted) by the vacuu m pump 246 so that the pressure inside the process chamber 201 reaches a desired pressure (sta te of vacuum). In this operation, an internal pressure of the process chamber 201 is measured b y the pressure sensor 245, and the APC valve 244 is feedback-controlled based on pressure infor mation detected. Furthermore, the wafers 200 in the process chamber 201 are heated by the he ater 207 to reach a desired processing temperature. In this operation, a state of supplying an ele ctric power to the heater 207 is feedback-controlled based on temperature information detected by the temperature sensor 263 such that a temperature distribution inside the process chamber 201 becomes a desired temperature distribution. Moreover, the rotation of the wafers 200 by th e rotator 267 is started. The exhaust of the inside of the process chamber 201 and the heating an d rotation of the wafers 200 may be continuously performed at least until the processing on the wafers 200 is completed.

(Film-forming Step)

Thereafter, the following inhibitor supply step, precursor supply step, and reactant suppl y step are performed in the named order.

[Inhibitor Supply Step]

In this step, the inhibitor is supplied to the wafer 200 that includes the surface including the first adsorption sites and the second adsorption sites.

Specifically, the valve 243a is opened to allow the inhibitor to flow into the gas supply pi pe 232a. A flow rate of the inhibitor is regulated by the MFC 241a. The inhibitor is supplied int o the process chamber 201 through the nozzle 249a, and is exhausted from the exhaust port 231 a. At this time, the inhibitor is supplied to the wafer 200 from a lateral side of the wafer 200 (in hibitor supply). At this time, the valves 243d to 243f may be opened to supply an inert gas into t he process chamber 201 through the respective nozzles 249a to 249c.

By supplying the inhibitor under a processing condition shown below to the wafer 200 in cluding the surface described above, it becomes possible to cause the inhibitor to be adsorbed to entire adsorption sites on the surface of the wafer 200, i.e., the first adsorption sites located at t he bottom side of the recesses, and the second adsorption sites located at the upper side of the re cesses. As a result, as shown in FIG. 5B, the entire adsorption sites on the surface of the wafer 2 00 are covered with the inhibitor.

The processing condition when supplying the inhibitor in the inhibitor supply step are ex emplified as follows.

Processing temperature: 300 to 850 degrees C, preferably 500 to 750 degrees C

Processing pressure: 1 to 5000 Pa

Supply flow rate of inhibitor: 0.05 to 10 slm

Supply time of inhibitor: 5 to 300 seconds

Supply flow rate of inert gas (for each gas supply pipe): 0 to 20 slm

In the present disclosure, the expression of a numerical range such as "1 to 5000 Pa" me ans that a lower limit and an upper limit are included in the range. Therefore, for example, "1 to 5000 Pa" means "1 Pa or more and 5000 Pa or less." The same applies to other numerical range s. Further, a processing temperature in the present disclosure means a temperature of the wafer 200 or a temperature inside the process chamber 201, and a processing pressure means a pressu re inside the process chamber 201. Moreover, a processing time means a time during which the processing is continued. In addition, when 0 slm is included in the supply flow rate, 0 slm mean s a case where the substance (gas) is not supplied. The same applies to the following description

As the inhibitor, for example, a substance containing halogen may be used. The halogen includes at least one selected from the group of fluorine (F), chlorine (Cl), bromine (Br), and iod ine (I). Examples of the inhibitor may include a fluorine ($F_2$) gas, a chlorine ($Cl_2$) gas, a bromin e ($Br_2$) gas, an iodine ($I_2$) gas, a nitrogen fluoride ($NF_3$) gas, a chlorine fluoride ($ClF_3$) gas, a hydr ogen fluoride (HF) gas, a hydrogen chloride (HCl) gas, a hydrogen bromide (HBr) gas, a hydroge n iodide (HI) gas, and the like. That is, as the inhibitor, for example, a simple halogen, an inter-halogen compound, a nitrogen halide, a hydrogen halide, and the like may be used.

Further, as the inhibitor, for example, a substance containing amine may be used. The s ubstance containing amine includes carbon (C), nitrogen (N), and hydrogen (H). The substance containing amine is also referred to as an amine-based substance (amine-based gas). As the inh ibitor, for example, chain amine-based substances (chain amine-based gas) such as a triethylami ne (($C_2H_5$)$_3$N) gas, a diethylamine (($C_2H_5$)$_2$NH) gas, a monoethylamine (($C_2H_5$)$NH_2$) gas, a trime thylamine (($CH_3$)$_3$N) gas, a dimethylamine (($CH_3$)$_2$NH) gas, a monomethylamine (($CH_3$)$NH_2$) ga s, and the like may be used.

One or more of these substances may be used as the inhibitor.

The molecular size of the inhibitor is preferably smaller than the molecular size of the pr ecursor used in the precursor supply step described below, and is also preferably smaller than th e molecular size of the intermediate produced from the precursor in the precursor supply step.

As the inert gas, a nitrogen ($N_2$) gas, or a rare gas such as an argon (Ar) gas, a helium (He ) gas, a neon (Ne) gas or a xenon (Xe) gas and the like may be used. One or more of these gases may be used as the inert gas. This applies the same to each step described later.

After the inhibitor is adsorbed to the entire adsorption sites on the surface of the wafer 2 00, the valve 243a is closed to stop supplying the inhibitor into the process chamber 201. Then, the inside of the process chamber 201 is vacuum-exhausted to remove gaseous substances remai ning inside the process chamber 201 from the inside of the process chamber 201. At this time, t he valves 243d to 243f are opened to supply the inert gas into the process chamber 201 through the nozzles 249a to 249c. The inert gas supplied from the nozzles 249a to 249c acts as a purge g as, thereby purging the inside of the process chamber 201 (purging). A processing temperature when purging is performed in this step is preferably the same as a processing temperature when the inhibitor is supplied.

[Precursor Supply Step]

After the inhibitor supply step is completed, the precursor is supplied to the wafer 200, i. e., the wafer 200 after the inhibitor is adsorbed to the first adsorption sites and the second adsor ption sites.

Specifically, the valve 243b is opened to allow the precursor to flow into the gas supply pi pe 232b. A flow rate of the precursor is regulated by the MFC 241b. The precursor is supplied in to the process chamber 201 through the nozzle 249b and is exhausted through the exhaust port 231a. At this time, the precursor is supplied to the wafer 200 from the lateral side of the wafer 2 00 (precursor supply). At this time, the valves 243d to 243f may be opened to supply the inert g as into the process chamber 201 through the respective nozzles 249a to 249c.

By supplying the precursor under a processing condition shown below to the wafer 200 o n which the inhibitor is adsorbed to the entire adsorption sites, it becomes possible to thermally decompose the precursor, to thereby produce the intermediate from the precursor. Furthermor e, by allowing the precursor or the intermediate to react with the inhibitor adsorbed to the secon d adsorption sites, it is possible to desorb and remove the inhibitor, reacted with the precursor o r the intermediate, from the second adsorption sites. Moreover, it becomes possible to adsorb t he precursor and the intermediate to the second adsorption sites from which the inhibitor is des orbed. As a result, as shown in FIG. 5C, it becomes possible to form the first layer containing th e precursor and the intermediate on the surface of the wafer 200.

Herein, the atoms constituting the second adsorption sites constitute the steric hindranc e that inhibits the precursor from reaching the first adsorption sites, as described above. Theref ore, in the precursor supply step, it is possible to suppress the reaction between the inhibitor ads orbed to the first adsorption sites and the precursor.

The molecular size of the intermediate is smaller than that of the precursor. As mention ed above, when the separation distance D is longer than the width of the molecule of the interme diate such that the molecule of the intermediate is able to pass, the atoms constituting the secon d adsorption sites do not constitute the steric hindrance that inhibits the precursor from reachin g the first adsorption sites. However, even in this case, the inhibitor adsorbed to the second ads orption sites is located on an outermost surface of the wafer 200, and the inhibitor adsorbed to t he first adsorption sites is located at a deep place at the bottom side of the recesses. Therefore, i n the precursor supply step, a probability of a reaction between the inhibitor adsorbed to the firs t adsorption sites and the intermediate may be made lower than a probability of a reaction betw een the inhibitor adsorbed to the second adsorption sites and the intermediate. Accordingly, in the precursor supply step, it is possible to suppress both a reaction between the inhibitor adsorb ed to the first adsorption sites and the precursor, and the reaction between the inhibitor adsorbe d to the first adsorption sites and the intermediate.

As a result, in the precursor supply step, it is possible to maintain at least a part of the in hibitor adsorbed to the first adsorption sites by suppressing desorption of the inhibitor from the first adsorption sites, and it is possible to selectively desorb and remove the inhibitor adsorbed t o the second adsorption sites, among the inhibitor adsorbed to the first adsorption sites and the second adsorption sites. In the precursor supply step, by maintaining at least a part of the inhibi tor adsorbed to the first adsorption sites, it is possible to suppress adsorption of the intermediat e to the first adsorption sites, making it possible to keep an adsorption amount (adsorption rate) of the intermediate adsorbed to the second adsorption sites larger (higher) than an adsorption a mount (adsorption rate) of the intermediate adsorbed to the first adsorption sites. As a result, i n the precursor supply step, as shown in FIG. 5C, it becomes possible to selectively cause the pre cursor and the intermediate to be adsorbed to the second adsorption sites while maintaining a st ate in which the first adsorption sites are buried (covered) with the inhibitor.

The processing condition when supplying the precursor in the precursor supply step are exemplified as follows.

Processing temperature: 300 to 850 degrees C, preferably 500 to 750 degrees C

Processing pressure: 1 to 2000 Pa

Supply flow rate of precursor: 0.05 to 3 slm, preferably 0.1 to 2 slm

Supply time of precursor: 1 to 120 seconds, preferably 1 to 60 seconds

Supply flow rate of inert gas (for each gas supply pipe): 0 to 20 slm

As the precursor, for example, a substance containing a halogen and a main element con stituting a film may be used. The halogen includes at least one selected from the group of fluori ne (F), chlorine (Cl), bromine (Br), and iodine (I). The main element constituting a film include s a semiconductor element such as silicon (Si) or the like.

As the precursor, for example, a gas containing Si and a halogen, i.e., a halosilane-based gas may be used. Examples of the precursor may include a fluorosilane-based gas such as a diflu orosilane ($SiH_2F_2$) gas or the like, a chlorosilane-based gas such as a monochlorosilane ($SiH_3Cl$) gas, a dichlorosilane ($SiH_2Cl_2$) gas, a trichlorosilane ($SiHCl_3$) gas, a hexachlorodisilane ($Si_2Cl_6$) g as, an octachlorotrisilane ($Si_3Cl_8$) gas or the like, a bromosilane-based gas such as a dibromosila ne ($SiH_2Br_2$) gas or the like, and an iodosilane-based gas such as diiodosilane ($SiH_2I_2$) gas or the like.

Further, as the precursor, for example, a gas containing Si and an amino group, i.e., an a minosilane-based gas may be used. Examples of the precursor may include an aminosilane-base d gas such as a tetrakis(dimethylamino)silane ($Si[N(CH_3)_2]_4$) gas, a tris(dimethylamino)silane (S i[N(CH_3)_2]_3H$) gas, a bis(diethylamino)silane ($Si[N(C_2H_5)_2]_2H_2$) gas, a bis(tert-butylamino)silane ($SiH_2[NH(C_4H_9)]_2$) gas, a (diisopropylamino)silane ($SiH_3[N(C_3H_7)_2]$) gas or the like.

One or more of these gases may be used as the precursor.

In addition, for example, when using the above-mentioned halosilane-based gas as the p recursor, a substance with a molecular structure such as SiHF, $SiF_2$, SiHCl, $SiCl_2$, SiHBr, $SiBr_2$, S iHI, $SiI_2$ or the like is produced as the intermediate. In this case, it is preferable to use, for exam ple, a substance containing halogen as the inhibitor. Further, for example, when using the abov e-mentioned aminosilane-based gas as the precursor, a substance with a molecular structure in which at least one selected from the group of an amino group, a part of an amino group and hyd rogen is removed from the molecule of the precursor is produced as the intermediate. In this ca se, it is preferable to use, for example, a substance containing an amine as the inhibitor.

After forming the first layer on the surface of the wafer 200, the valve 243b is closed to st op supplying the precursor into the process chamber 201. Then, gaseous substances or the like r emaining in the process chamber 201 are removed (purging) from the process chamber 201 usin g the same processing procedure and processing condition as those for purging in the inhibitor s upply step. A processing temperature when purging is performed in this step is preferably the s ame as a processing temperature when precursor is supplied.

[Reactant Supply Step]

After the precursor supply step is completed, the reactant is supplied to the wafer 200, i. e., the wafer 200 on which the first layer is formed by selectively adsorbing the precursor and th e intermediate to the second adsorption sites among the adsorption sites on the surface of the w afer 200.

Specifically, the valve 243c is opened to allow the reactant to flow into the gas supply pip e 232c. A flow rate of the reactant is regulated by the MFC 241c. The reactant is supplied into th e process chamber 201 through the nozzle 249c and is exhausted through the exhaust port 231a. At this time, the reactant is supplied to the wafer 200 from the lateral side of the wafer 200 (rea ctant supply). At this time, the valves 243d to 243f may be opened to supply the inert gas into th e process chamber 201 through the respective nozzles 249a to 249c.

By supplying the reactant under a processing condition shown below to the wafer 200 aft er forming the first layer, as shown in FIG. 5D, it becomes possible to cause at least a portion of t he first layer to react with the reactant to modify the first layer into the second layer.

At this time, it becomes possible to remove the inhibitor remaining at the first adsorptio n sites in the precursor supply step from the surface of the wafer 200 by an action of the reactan t. This makes it possible to prevent the inhibitor from remaining in the film finally formed on th e surface of the wafer 200. As shown in FIG. 5D, the inhibitor may not be completely removed f rom the surface of the wafer 200, and a small amount of the inhibitor may remain in the film fin ally formed on the surface of the wafer 200. The region from which the inhibitor is removed ma y be filled by adsorption of atoms and molecules that constitute the reactant, or may be filled by migration of atoms and molecules that constitute the precursor.

The processing condition when supplying the reactant in the reactant supply step are exe mplified as follows.

Processing temperature: 300 to 850 degrees C, preferably 500 to 750 degrees C

Processing pressure: 1 to 4000 Pa

Supply flow rate of reactant: 1 to 30 slm, preferably 2 to 20 slm

Supply time of reactant: 1 to 120 seconds, preferably 1 to 60 seconds

Supply flow rate of inert gas (for each gas supply pipe): 0 to 20 slm

As the reactant, a substance containing at least one selected from the group of nitrogen a nd oxygen may be used.

As the reactant, for example, a nitrogen (N)- and hydrogen (H)-containing substance (N- and H-containing gas) may be used. Examples of the N- and H-containing substance may inclu de a hydrogen nitride-based gas such as a diazene ($N_2H_2$) gas, a hydrazine ($N_2H_4$) gas, an ammo nia ($NH_3$) gas, a $N_3H_8$ gas or the like, an ethylamine-based gas such as a monoethylamine ($C_2H_5 NH_2$) gas, a diethylamine (($C_2H_5$)$_2$NH) gas, a triethylamine (($C_2H_5$)$_3$N) gas or the like, a methyla mine-based gas such as a monomethylamine ($CH_3NH_2$) gas, a dimethylamine (($CH_3$)$_2$NH) gas, a trimethyl-amine (($CH_3$)$_3$N) gas or the like, and an organic hydrazine-based gas such as a monom ethylhydrazine (($CH_3$)$HN_2H_2$) gas, a dimethylhydrazine (($CH_3$)$_2N_2H_2$) gas, a trimethylhydrazine (($CH_3$)$_2N_2(CH_3$)H) gas or the like.

Further, as the reactant, for example, an oxygen (O)-containing substance (O-containing gas) may be used. Examples of the O-containing substance may include an oxygen ($O_2$) gas, an o zone ($O_3$) gas, a water vapor ($H_2O$ gas), a hydrogen peroxide ($H_2O_2$) gas, a hydrogen ($H_2$) gas + o xygen ($O_2$) gas, a deuterium ($D_2$) gas + oxygen ($O_2$) gas, oxygen radicals ($O_2$* or O*), atomic oxyg en (O), and the like. The description of two gases together, such as "$H_2$ gas + $O_2$ gas" in the pres ent disclosure means a mixed gas of $H_2$ gas and $O_2$ gas. When supplying the mixed gas, the two gases may be mixed (premixed) in a supply pipe and then supplied into the process chamber 201 , or the two gases may be separately supplied into the process chamber from different supply pip es and then mixed (post-mixed) within the process chamber 201.

One or more of these gases may be used as the reactant.

In addition, when using, for example, the N- and H-containing substance as the reactant, it is preferable to use, for example, a substance containing halogen as the inhibitor, and it is pref erable to use, for example, a halosilane-based gas as the precursor. Moreover, when using, for e xample, the O-containing substance as the reactant, it is preferable to use, for example, a substa nce containing an amine as the inhibitor, and it is preferable to use, for example, an aminosilane -based gas as the precursor.

After the first layer formed on the surface of the wafer 200 is changed to the second layer, the valve 243c is closed to stop supplying the reactant into the process chamber 201. Then, gas eous substances or the like remaining in the process chamber 201 are removed (purging) from t he process chamber 201 using the same processing procedure and processing condition as those for purging in the inhibitor supply step. A processing temperature when purging is performed i n this step is preferably the same as a processing temperature when the reactant is supplied.

[Performing a Cycle a Predetermined Number of Times]

By performing, n times (where n is an integer of 1 or 2 or more), a cycle that performs th e inhibitor supply step, the precursor supply step and the reactant supply step non-simultaneous ly, i.e., without synchronization, in the named order, it is possible to form a film with a desired c omposition on the surface of the wafer 200. When the above-mentioned silane-based gas is use d as the precursor and the above-mentioned nitrogen-containing gas is used as the reactant, a sil icon nitride film (SiN film) is formed on the surface of the wafer 200. Further, when the above-mentioned silane-based gas is used as the precursor and the above-mentioned oxygen-containin g gas is used as the reactant, a silicon oxide film (SiO film) is formed on the surface of the wafer 200. Preferably, the above-described cycle is performed multiple times. That is, the thickness o f the second layer formed per cycle is set to be thinner than a desired film thickness, and the abo ve-described cycle is performed multiple times until the thickness of the film formed by stacking the second layers reaches the desired film thickness.

(After-Purge and Atmospheric Pressure Restoration)

After the film-forming step is completed, an inert gas as a purge gas is supplied into the process chamber 201 from each of the nozzles 249a to 249c and is exhausted through the exhaus t port 231a. Thus, the inside of the process chamber 201 is purged such that the gases, reaction by-products, and the like remaining in the process chamber 201 are removed from the inside of t he process chamber 201 (after-purge). Thereafter, the atmosphere in the process chamber 201 i s replaced with an inert gas (inert gas replacement), and the pressure in the process chamber 20 1 is returned to the atmospheric pressure (atmospheric pressure restoration).

(Boat Unloading and Wafer Discharging)

Thereafter, the seal cap 219 is lowered by the boat elevator 115 to open the lower end of t he manifold 209. Then, the processed wafers 200, while being supported by the boat 217, are un loaded from the lower end of the manifold 209 to the outside of the reaction tube 203 (boat unlo ading). After the boat is unloaded, the shutter 219s is moved and the lower end opening of the manifold 209 is sealed by the shutter 219s via the O-ring 220c (shutter closing). The processed wafers 200 are discharged from the boat 217 after being unloaded from the reaction tube 203 (w afer discharging).

(3) Effects of the Embodiments

According to the embodiments of the present disclosure, one or more of the following eff ects may be obtained.

(a) In the inhibitor supply step, the inhibitor is first adsorbed to the entire adsorption sit es (the first adsorption sites and the second adsorption sites) and then, in the precursor supply s tep, the inhibitor adsorbed to the second adsorption sites, among the inhibitor adsorbed to the fi rst adsorption sites and the second adsorption sites, is selectively desorbed and removed, and th e precursor and the intermediate are allowed to be selectively adsorbed to the second adsorption sites. Therefore, it is possible to reduce the adsorption amount (adsorption rate) of the interme diate on the entire adsorption sites. As a result, a step coverage of the film formed on the surfac e of the wafer may be greatly improved, making the film a conformal film.

Herein, since the intermediate is produced by a gas phase reaction, an amount of the inte rmediate supplied is larger in an upper side of a trench, a hole or the like where the space is relat ively wide than in a middle side or a bottom side. Further, the intermediate is adsorbed without being saturated as in a CVD reaction. That is, a relatively large amount of the intermediate tend s to be adsorbed to the upper side of a trench, a hole or the like, and this becomes a factor that d eteriorates the step coverage. This tendency is exacerbated as the amount of the intermediate a dsorbed to the entire adsorption sites of a trench, a hole or the like increases. In contrast, accor ding to the present disclosure, it is possible to reduce the adsorption amount (adsorption rate) o f the intermediate adsorbed to the entire adsorption sites including the upper side of a trench, a hole or the like. This makes it possible to suppress the tendency that a relatively large amount o f the intermediate is absorbed to the upper side of a trench, a hole or the like. As a result, it beco mes possible to significantly improve the step coverage.

When performing the precursor supply step without performing the inhibitor supply ste p, it may be difficult to selectively adsorb the precursor and the intermediate to the second adsor ption sites, among the first adsorption sites and the second adsorption sites of the surface of the wafer, and thus the above-mentioned effects may not be obtained. This will be explained below using FIGS. 6A to 6C.

FIG. 6A is a schematic cross-sectional view showing a surface state of a wafer including, on a surface, first adsorption sites and second adsorption sites. The surface state of the wafer sh own in this figure is similar to the surface state of the above-described wafer shown in FIG. 5A. When the precursor supply step is performed on the wafer with such a surface state without perf orming the inhibitor supply step, the precursor and the intermediate may be adsorbed to the sec ond adsorption sites, and the intermediate may also be adsorbed to the first adsorption sites, as shown in FIG. 6B. That is, if the inhibitor supply step is not performed before performing the pr ecursor supply step, it may be difficult to reduce the amount (adsorption rate) of the intermediat e adsorbed to the entire adsorption sites as compared with the method shown in the embodimen ts of the present disclosure. In this case, a first layer formed on the surface of the wafer may con tain a large amount of intermediate components. If the reactant supply step is performed in this state, as shown in FIG. 6C, a second layer formed on the surface of the wafer may contain a large amount of intermediate components, and a step coverage of the second layer may be lower than that of the film formed on the surface of the wafer by the method shown in the embodiments of t he present disclosure. This may make it difficult to form this film into a conformal film.

(b) The first adsorption sites are located at the bottom side of the recess of the surface of the wafer, and the second adsorption sites are located at the upper side thereof. Therefore, in th e precursor supply step, a reaction probability among the inhibitor adsorbed to the second adsor ption sites, the precursor and the intermediate is possible to be made higher than a reaction pro bability among the inhibitor adsorbed to the first adsorption sites, the precursor and the interm ediate. Thus, in the precursor supply step, it becomes possible to effectively perform selectively desorption and removal of the inhibitor adsorbed to the second adsorption sites and selective ad sorption of the precursor and the intermediate to the second adsorption sites. As a result, it is p ossible to reduce the adsorption amount (adsorption rate) of the intermediate adsorbed to the e ntire adsorption sites, greatly improving the step coverage of the film formed on the surface of t he wafer, and making the film more conformal.

(c) By making the molecular size of the inhibitor smaller than the molecular size of the pr ecursor, in the inhibitor supply step, it is possible to cause the inhibitor to be uniformly adsorbe d on both the bottom side of the recesses where molecules are difficult to enter and the upper si de of the recesses. This makes it possible to create a state in which insides of the recesses are fill ed with the inhibitor, i.e., a state in which the insides of the recesses are blocked with the inhibit or. As a result, it becomes possible to allow the above-mentioned reaction to occur effectively.

(d) By making the molecular size of the inhibitor the smallest among the precursor, the i ntermediate and inhibitor, in the inhibitor supply step, it is possible to cause the inhibitor to be uniformly adsorbed on both the bottom side of the recesses where molecules are difficult to ente r and the upper side of the recesses. This makes it possible to create a state in which the insides of the recesses are filled with the inhibitor, i.e., a state in which the insides of the recesses are bl ocked with the inhibitor. As a result, it becomes possible to allow the above-mentioned reaction to occur effectively.

(e) Since the above-mentioned separation distance D is shorter than the width of the mol ecule of the precursor and is set such that the molecule of the precursor is not able to pass throu gh, the atoms constituting the second adsorption sites constitute the steric hindrance that inhibi ts adsorption of the precursor to the first adsorption sites. Thus, in the precursor supply step, it is possible to inhibit adsorption of the precursor to the first adsorption sites while allowing the p recursor to be adsorbed to the second adsorption sites. As a result, it becomes possible to allow the above-mentioned reaction to occur effectively.

(f) Since the above-mentioned separation distance D is a distance longer than the width of the molecule of the intermediate and longer than the width of the molecule of the inhibitor, i. e., a distance set such that each molecule of the intermediate and the inhibitor is able to pass thr ough, the intermediate are able to be adsorbed to the first adsorption sites and the second adsor ption sites in the precursor supply step. Furthermore, in the inhibitor supply step, the inhibitor are able to be adsorbed to the first adsorption sites and the second adsorption sites. As a result, it becomes possible to allow the above-mentioned reaction to occur effectively.

(g) In the precursor supply step, by maintaining at least a part of the inhibitor adsorbed t o the first adsorption sites and maintaining the state in which the first adsorption sites are filled with the inhibitor, it becomes possible to effectively promote selective adsorption of the precurs or and the intermediate to the second adsorption sites while suppressing adsorption of the inter mediate to the first adsorption sites. That is, in the precursor supply step, by making the amoun t of the intermediate adsorbed to the second adsorption sites larger than the amount of the inter mediate adsorbed to the first adsorption sites, it is possible to effectively reduce the adsorption a mount (adsorption rate) of the intermediate adsorbed to the entire adsorption sites. As a result, it becomes possible to significantly improve the step coverage of the film formed on the surface of the wafer.

(h) In the reactant supply step, when the reactant is supplied to the wafer and the first la yer is modified into the second layer, the inhibitor remaining at the first adsorption sites in the p recursor supply step may be removed by the action of the reactant. As a result, it is possible to s uppress the inhibitor from remaining in the film formed on the surface of the wafer.

(i) In the above-described cycle, by performing the inhibitor supply step, the precursor s upply step and the reactant supply step in the named order, it is possible to allow the above-men tioned reaction to occur effectively.

(j) Since the inhibitor contains halogen and the precursor contains halogen and a main el ement constituting a film, it is possible to allow the above-mentioned reaction to occur effectivel y. Moreover, since the reactant contains at least one selected from the group of nitrogen and ox ygen, it is possible to allow the above-mentioned reaction to occur effectively.

(k) By using the halogen-containing substance as the inhibitor, using the halosilane-base d gas as the precursor, and using the N- and H-containing substance as the reactant, it is possibl e to allow the above-mentioned reaction to occur more effectively. Further, by using the substan ce containing amine as the inhibitor, using the aminosilane-based gas as the precursor, and usin g the O-containing substance as the reactant, it is possible to allow the above-mentioned reactio n to occur more effectively.

(l) The above-mentioned effects may be obtained similarly even when predetermined sub stances are arbitrarily selected from the above-mentioned various precursors, various reactants, various inhibitors, and various inert gases.

< Other Embodiments of the Present Disclosure>

Embodiments of the present disclosure are specifically described above. However, the pr esent disclosure is not limited to the above-described embodiments, and various changes may b e made without departing from the gist thereof. Other embodiments of the present disclosure w ill be described below. Unless otherwise specified, the processing procedure and processing con dition in each step of the other embodiments described below may be the same as the processing procedure and processing condition in each step of the above-described processing sequence.

For example, after performing the above-described film-forming step, a predetermined p ost-treatment may be performed on the film formed on the surface of the substrate.

Examples of the post-treatment include a heat treatment in an atmosphere containing a predetermined post-treatment substance (post-treatment gas), a plasma treatment using a post-treatment substance, and the like. As the post-treatment substance, the various reactants menti oned above, for example, reactive gases such as an $NH_3$ gas, an $O_2$ gas, a $H_2$ gas, a $D_2$ gas and the like, inert gases such as a He gas, an Ar gas, an $N_2$ gas and the like, and mixtures of these gases may be used. As the post-treatment substance, one or more of these gases may be used. The po st-treatment may be performed in a same process chamber (in-situ) as the process chamber in w hich the film-forming step is performed, or may be performed in a process chamber (ex-situ) dif ferent from the process chamber in which the film-forming step is performed.

The processing condition when performing the post-treatment are exemplified as follows

Processing temperature: 300 to 1000 degrees C, preferably 200 to 800 degrees C

Processing pressure: 1 to 4000 Pa, preferably 1 to 1000 Pa

Supply flow rate of post-treatment substance: 0.01 to 10 slm, preferably 1 to 10 slm

Substance supply time of post-treatment substance: 1 to 18000 seconds, preferably 120 to 10800 seconds

Supply flow rate of inert gas (for each gas supply pipe): 0 to 20 slm

RF power: 1 to 10000 W, preferably 10 to 5000 W

In addition, the RF power refers to a power which is applied to generate plasma when p erforming the plasma treatment using the post-treatment substance.

Also in these embodiments, the same effects as in the above-described embodiments ma y be obtained. Furthermore, by performing the post-treatment, it becomes possible to remove t he inhibitor remaining in the film formed on the surface of the substrate.

For example, as in a processing sequence denoted below, in the above-mentioned cycle, a n act of performing an inhibitor supply step, and an act of performing a set including a precurso r supply step and a reactant supply step a predetermined number of times (m times where m is a n integer of 1 or 2 or more) may be performed. Also in these embodiments, the same effects as i n the above-described embodiments may be obtained.

$$[\text{inhibitor} \to (\text{precursor} \to \text{reactant}) \times m] \times n$$

For example, as in the processing sequences denoted below, multi-component films such as a silicon oxynitride film (SiON film), a silicon oxycarbonate film (SiOC film), a silicon oxycarb onitride film (SiOCN film), a silicon carbonitride film (SiCN film), a silicon boronitride film (SiB N film), a silicon borocarbonitride film (SiBCN film), a silicon borooxynitride film (SiBON film), a silicon borooxycarbonitride film (SiBOCN film), and the like may be formed on the surface of t he substrate using multiple types of the reactant. In addition to the various types of the reactant mentioned above, a carbon (C)-containing gas such as a propylene ($C_3H_6$) gas or the like, and a b oron (B)-containing gas such as a boron trichloride ($BCl_3$) gas or the like may be used as a first r eactant, a second reactant, and a third reactant. Also in these embodiments, the same effects as in the above-described embodiments may be obtained.

$$(\text{inhibitor} \to \text{precursor} \to \text{first reactant} \to \text{second reactant}) \times n$$

$$(\text{inhibitor} \to \text{precursor} \to \text{first reactant} \to \text{second reactant} \to \text{third reactant}) \times n$$

$$[\text{inhibitor} \to (\text{precursor} \to \text{first reactant} \to \text{second reactant}) \times m] \times n$$

$$[\text{inhibitor} \to (\text{precursor} \to \text{first reactant} \to \text{second reactant} \to \text{third reactant}) \times m] \times n$$

The present disclosure may be suitably applied to cases where films containing metal ele ments, such as a hafnium oxide film (HfO film), a zirconium oxide film (ZrO film), an aluminum oxide film (AlO film), a titanium oxide film (TiO film), a tungsten oxide film (WO film), a hafniu m nitride film (HfN film), a zirconium nitride film (ZrN film), an aluminum nitride film (AlN fil m), a titanium nitride film (TiN film), a tungsten nitride film (WN film), a hafnium oxynitride fil m (HfON film), a zirconium oxynitride film (ZrON film), an aluminum oxynitride film (AlON fil m), a titanium oxynitride film (TiON film), a tungsten oxynitride film (WON film), and the like, are formed on the surface of the substrate. Also in these embodiments, the same effects as in th e above-described embodiments may be obtained.

The recipe used for each process may be prepared separately according to processing con tents and may be recorded and stored in the memory 121c via an electric communication line or the external memory 123. When starting each process, the CPU 121a may properly select an app ropriate recipe from a plurality of recipes recorded and stored in the memory 121c according to t he processing contents. This makes it possible to form films of various film types, composition r atios, film qualities and film thicknesses with high reproducibility in one substrate processing ap paratus. In addition, the burden on an operator may be reduced, and each process may be quick ly started while avoiding operation errors.

The above-described recipes are not limited to newly prepared ones, but may be prepare d by, for example, changing existing recipes already installed in the substrate processing apparat us. In the case of changing the recipes, the recipes after the change may be installed in the subst rate processing apparatus via an electric communication line or a recording medium in which th e recipes are recorded. In addition, the input/output device 122 installed in the existing substrat e processing apparatus may be operated to directly change the existing recipes already installed i n the substrate processing apparatus.

In the above-described embodiments, there is described the example in which a film is fo rmed by using a batch type substrate processing apparatus configured to process a plurality of s ubstrates at a time. The present disclosure is not limited to the above-described embodiments, but may be suitably applied to, for example, a case where a film is formed using a single-wafer ty pe substrate processing apparatus configured to process one or several substrates at a time. Fur thermore, in the above-described embodiments, there is described the example in which a film i s formed using a substrate processing apparatus including a hot-wall-type process furnace. The present disclosure is not limited to the above-described embodiments, but may also be suitably applied to a case where a film is formed using a substrate processing apparatus including a cold -wall-type process furnace.

Even when these substrate processing apparatuses are used, each process may be perfor med under the processing procedures and processing conditions as those of the above-described embodiments and modifications. The same effects as those of the above-described embodiment s and modifications may be obtained.

The above-described embodiment and modifications may be used in combination as app ropriate. The processing procedures and processing conditions at this time may be, for example , the same as the processing procedures and processing conditions of the above-described embo diments and modifications.

According to the present disclosure in some embodiments, it is possible to improve chara cteristics of a film formed on a substrate.

While certain embodiments are described above, these embodiments are presented by w ay of example, and are not intended to limit the scope of the disclosures. Indeed, the embodime nts described herein may be embodied in a variety of other forms. Furthermore, various omissi ons, substitutions, and changes in the form of the embodiments described herein may be made without departing from the spirit of the disclosures. The accompanying claims and their equival ents are intended to cover such forms or modifications as would fall within the scope and spirit of the disclosures.

**Claims**

1.  A method of processing a substrate (200), comprising:
    forming a film on a surface of the substrate (200) by performing a cycle a predetermined number of times, the cycle including:

    (a) supplying an inhibitor to the substrate (200), which includes the surface incl uding first adsorption sites capable of adsorbing an intermediate produced from a precu rsor but incapable of adsorbing the precursor and second adsorption sites capable of ad sorbing the precursor and the intermediate, and causing the inhibitor to be adsorbed to the first adsorption sites and the second adsorption sites; and
    (b) supplying the precursor to the substrate (200) after the inhibitor is adsorbed to the first adsorption sites and the second adsorption sites, producing the intermediate from the precursor, desorbing the inhibitor adsorbed to the second adsorption sites, an d causing the precursor and the intermediate to be adsorbed to the second adsorption si tes to form a first layer.

2.  The method of Claim 1, wherein the surface of the substrate (200) includes a recess, the fi rst adsorption sites are located at a bottom side of the recess, and the second adsorption sites ar e located at an upper side of the recess.

3.  The method of Claim 2, wherein a molecular size of the intermediate is smaller than a mol ecular size of the precursor, and a molecular size of the inhibitor is smaller than the molecular si ze of the precursor.

4.  The method of Claim 2, wherein a molecular size of the intermediate is smaller than a mol ecular size of the precursor, and a molecular size of the inhibitor is smaller than the molecular si ze of the intermediate.

5.  The method of Claim 3, wherein atoms constituting the second adsorption sites constitute steric hindrance that inhibits adsorption of the precursor to the first adsorption sites.

6.  The method of Claim 3, wherein atoms constituting the second adsorption sites are separa ted in at least a portion of the second adsorption sites, and a distance between the atoms in sepa ration is shorter than a width of a molecule of the precursor.

7.  The method of Claim 6, wherein the distance between the atoms is longer than a width of a molecule of the intermediate and longer than a width of a molecule of the inhibitor.

8.  The method of Claim 3, wherein atoms constituting the second adsorption sites are separa ted in at least a portion of the second adsorption sites, and a distance between the atoms in sepa ration is a distance through which a molecule of the precursor is incapable of passing.

9.  The method of Claim 8, wherein the distance between the atoms is a distance through whi ch each molecule of the intermediate and the inhibitor is capable of passing.

10. The method of Claim 3, wherein in (b), the precursor is supplied under a condition in whi ch at least a part of the inhibitor adsorbed to the first adsorption sites is capable of being mainta ined and the inhibitor adsorbed to the second adsorption sites is capable of being desorbed.

11. The method of any one of Claims 1 to 10, wherein the cycle further includes: (c) supplying a reactant to the substrate (200) to modify the first layer into a second layer.

12. The method of any one of Claims 1 to 11, wherein the inhibitor contains halogen, and the p recursor contains halogen and a main element constituting the film.

**13.** A method of manufacturing a semiconductor device comprising the method of Claim 1.

**14.** A substrate processing apparatus, comprising:

a precursor supply system configured to supply a precursor to a substrate (200);
an inhibitor supply system configured to supply an inhibitor to the substrate (200);
a temperature regulator configured to regulate a temperature of the substrate (200); an d
a controller (121) configured to be capable of controlling the precursor supply system, th e inhibitor supply system, and the temperature regulator to perform a process including:
forming a film on a surface of the substrate (200) by performing a cycle a predetermine d number of times, the cycle including:

(a) supplying the inhibitor to the substrate (200), which includes the surface inc luding first adsorption sites capable of adsorbing an intermediate produced from the pr ecursor but incapable of adsorbing the precursor and second adsorption sites capable of adsorbing the precursor and the intermediate, and causing the inhibitor to be adsorbed to the first adsorption sites and the second adsorption sites; and
(b) supplying the precursor to the substrate (200) after the inhibitor is adsorbed to the first adsorption sites and the second adsorption sites, producing the intermediate from the precursor, desorbing the inhibitor adsorbed to the second adsorption sites, an d causing the precursor and the intermediate to be adsorbed to the second adsorption si tes to form a first layer.

**15.** A program that causes, by a computer, a substrate processing apparatus to perform a proc ess comprising:
forming a film on a surface of a substrate (200) by performing a cycle a predetermined number of times, the cycle including:

(a) supplying an inhibitor to the substrate (200), which includes the surface incl uding first adsorption sites capable of adsorbing an intermediate produced from a precu rsor but incapable of adsorbing the precursor and second adsorption sites capable of ad sorbing the precursor and the intermediate, and causing the inhibitor to be adsorbed to the first adsorption sites and the second adsorption sites; and
(b) supplying the precursor to the substrate (200) after the inhibitor is adsorbed to the first adsorption sites and the second adsorption sites, producing the intermediate from the precursor, desorbing the inhibitor adsorbed to the second adsorption sites, and causing the precursor and the intermediate to be adsorbed to the second adsorption sites to form a first layer.

# FIG. 1

## FIG. 2

FIG. 3

248

121

121a

CPU

121b

RAM

123

External memory

121c

Memory

122

Input/output
device

121d

I/O port

121e

MFC — 241a~241f

Valve — 243a~243f

Pressure
sensor — 245

APC valve — 244

Vacuum
pump — 246

Heater — 207

Temperature
sensor — 263

. . . .

Rotator — 267

Boat elevator — 115

Shutter opening
/closing
mechanism — 115s

# FIG. 4

## FIG. 5A

FIG. 5B

Inhibitor

Second
adsorption site

Non-adsorption
site

First
adsorption site

## FIG. 5C

FIG. 5D

## FIG. 6A

Second adsorption site

Non-adsorption site

First adsorption site

FIG. 6B

Intermediate    Precursor

Second
adsorption site

Non-adsorption
site

First
adsorption site

FIG. 6C

# FIG. 7

Hole or trench

Upper surface

Side surface

Bottom surface

Wafer

Europäisches
Patentamt

European
Patent Office

Office européen
des brevets

# EUROPEAN SEARCH REPORT

Application Number

EP 24 15 5984

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YARBROUGH JOSIAH ET AL: "Tuning Molecular Inhibitors and Aluminum Precursors for the Area-Selective Atomic Layer Deposition of Al 2 O 3", CHEMISTRY OF MATERIALS, vol. 34, no. 10, 10 May 2022 (2022-05-10), pages 4646-4659, XP093185841, US ISSN: 0897-4756, DOI: 10.1021/acs.chemmater.2c00513 Retrieved from the Internet: URL:https://pubs.acs.org/doi/pdf/10.1021/acs.chemmater.2c00513> * abstract * * figures 1, 2 * | 1-13 | INV. C23C16/02 C23C16/04 C23C16/34 C23C16/40 C23C16/455 C23C16/46 C23C16/52 C23C16/56 H01L21/02 |
| X | US 2022/230870 A1 (HASHIMOTO YOSHITOMO [JP] ET AL) 21 July 2022 (2022-07-21) * figures 1-3 * * paragraph [0047] - paragraph [0048]; figures 4A-4F * | 1-15 | |
| X | US 2016/148800 A1 (HENRI JON [US] ET AL) 26 May 2016 (2016-05-26) * paragraph [0048] - paragraph [0049] * | 1-13 | TECHNICAL FIELDS SEARCHED (IPC) C23C H01L |
| X | KHAN RIZWAN ET AL: "Area-Selective Atomic Layer Deposition Using Si Precursors as Inhibitors", CHEMISTRY OF MATERIALS, vol. 30, no. 21, 11 October 2018 (2018-10-11), pages 7603-7610, XP093004183, US ISSN: 0897-4756, DOI: 10.1021/acs.chemmater.8b02774 * abstract * * figures 1, 5 * | 1-13 | |

The present search report has been drawn up for all claims

| Place of search | Date of completion of the search | Examiner |
|---|---|---|
| The Hague | 25 July 2024 | Engelen, Karen |

EPO FORM 1503 03.82 (P04C01)

## ANNEX TO THE EUROPEAN SEARCH REPORT
## ON EUROPEAN PATENT APPLICATION NO.

EP 24 15 5984

This annex lists the patent family members relating to the patent documents cited in the above-mentioned European search report.
The members are as contained in the European Patent Office EDP file on
The European Patent Office is in no way liable for these particulars which are merely given for the purpose of information.

25-07-2024

| Patent document cited in search report | | Publication date | Patent family member(s) | | Publication date |
|---|---|---|---|---|---|
| US 2022230870 | A1 | 21-07-2022 | CN | 114807899 A | 29-07-2022 |
| | | | JP | 7303226 B2 | 04-07-2023 |
| | | | JP | 2022110465 A | 29-07-2022 |
| | | | KR | 20220104640 A | 26-07-2022 |
| | | | TW | 202230514 A | 01-08-2022 |
| | | | TW | 202347502 A | 01-12-2023 |
| | | | US | 2022230870 A1 | 21-07-2022 |
| US 2016148800 | A1 | 26-05-2016 | KR | 20160061885 A | 01-06-2016 |
| | | | KR | 20240000424 A | 02-01-2024 |
| | | | TW | 201629253 A | 16-08-2016 |
| | | | US | 2016148800 A1 | 26-05-2016 |
| | | | US | 2017117134 A1 | 27-04-2017 |
| | | | US | 2018138028 A1 | 17-05-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023026842 A